Europäisches Patentamt

European Patent Office

Office européen des brevets

(11) Publication number: 0 088 830
A1

# EUROPEAN PATENT APPLICATION

(21) Application number: 82112076.3

(22) Date of filing: 28.12.82

(51) Int. Cl.³: H 03 J 9/06
H 04 N 5/44, H 04 B 9/00

(30) Priority: 12.03.82 IT 4570982

(43) Date of publication of application:
21.09.83 Bulletin 83/38

(84) Designated Contracting States:
AT BE CH DE FR GB IT LI NL SE

(71) Applicant: ZANUSSI ELETTRONICA S.p.A.
Viale Treviso 15
I-33170 Pordenone(IT)

(72) Inventor: Masili, Dino
Via Manin 7
I-33080 Prata di Pordenone Pordenone(IT)

(72) Inventor: Muzzolini, Dario
Via Urana 23
I-33010 Magnano in Riviera Udine(IT)

(74) Representative: Patentanwälte Grünecker, Dr.
Kinkeldey, Dr. Stockmair, Dr. Schumann, Jakob, Dr.
Bezold, Meister, Hilgers, Dr. Meyer-Plath
Maximilianstrasse 58
D-8000 München 22(DE)

(54) Infrared telecommand receiver.

(57) The invention relates to an infrared telecommand receiver with automatic signal compensation. The receiver comprises a photodiode (10) for receiving a signal emitted by a transmitter in the form of amplitude-modified infrared radiation with two suitably alternating frequencies, an amplifier stage (15), a peak detector circuit (32-36) and an integrator stage (37, 38) adapted to control a comparator (42).

The improvement consists in that downstream of said amplifier stage (15) there is provided an attenuator circuit (22-26), followed by a controlled-gain amplifier (27) in combination with a discriminator filter (28-31).

FIG. 1

Infrared Telecommand Receiver

D e s c r i p t i o n

This invention relates to an improved infrared telecommand receiver particularly for controlling a television set.

As is generally known, telecommand systems of this type are adapted to emit and receive signals in the form of infrared rays, the amplitude of which is modulated, usually in accordance with the so-called FSK system, with two different frequencies alternating in a suitable manner in accordance with the command signal to be transmitted. These frequencies are usually designated F1 (41.6 kc) and F2 (50 kc).

A receiver for receiving telecommand signals of this type usually comprises a phase-locked loop circuit adapted to convert the received telecommand signal into a corresponding pulse train for controlling a microprocessor which is provided in the apparatus to be remotely controlled, and which is only able to receive digital signals at its input, as generally known.

The phase-locked loop circuit is particularly suitable for converting the received command signals into a digital code, its adjustment is very critical, however, detracting thus from reliability of operation.

It is therefore an object of the present invention to provide an infrared telecommand receiver which does not require any adjustment while still being of simple construction and reliably accurate operation.

The invention thus provides an infrared telecommand receiver comprising a photodiode for receiving a signal emitted by a transmitter device in the form of an amplitude-modulated train of infrared rays with two suitably
alternating frequencies F1 and F2, an amplification stage,
a peak indicator circuit and an integrating stage adapted
to control a comparator circuit.

According to the invention, a receiver of this type is
characterized in that downstream of the amplification
stage there is provided a limiter circuit followed by
a controlled-gain amplifyer provided with a discriminating filter.

These and other characteristics of the invention will
become evident from the following description of an
exemplary embodiment with reference to the accompanying
drawings, wherein:

fig. 1 shows a circuit diagram of a receiver in a preferred embodiment of the invention, and
fig. 2 to 9 show the shape of signals appearing at
significant points of the circuit shown in fig. 1.

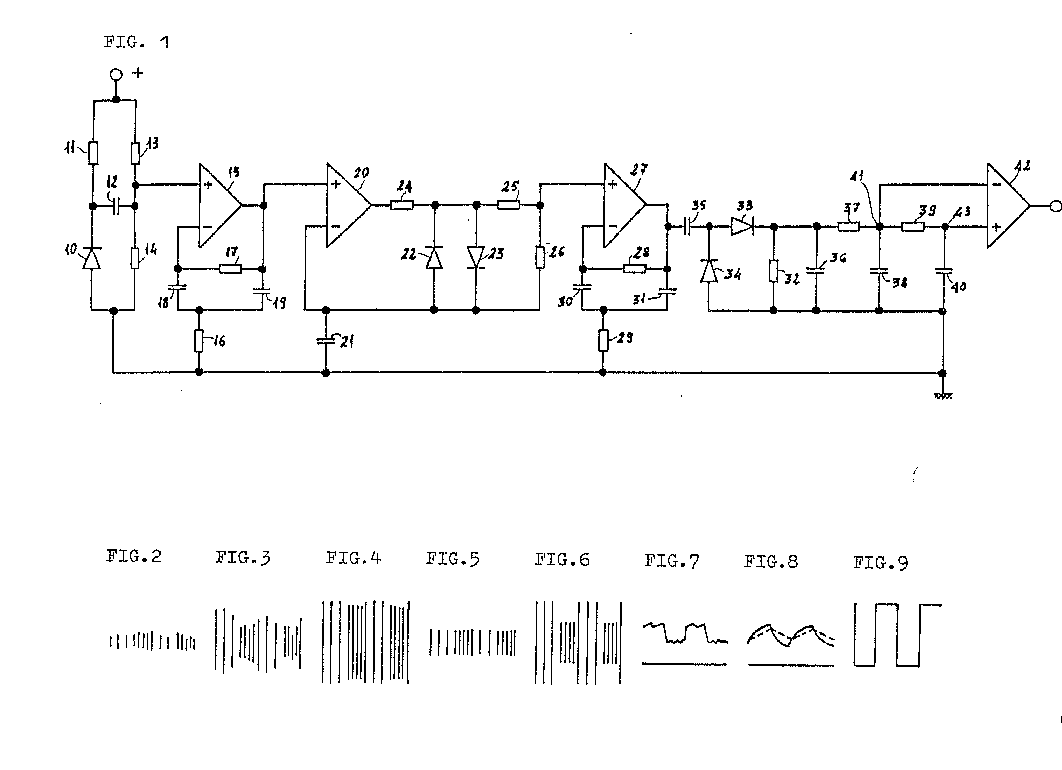

The receiver according to the invention comprises a
photodiode 10, connected as shown in fig. 1, for receiv-
ing signals emitted by a transmitter in a per se known
manner. These signals are in the form of a train of
infrared rays, the amplitude of which is modulated
according to the FSK system, with two different frequencies F1 and F2 alternating in accordance with the commands
to be transmitted.

Photodiode 10 is connected to a load resistor 11 and,
through a neutralizing capacitor 12, to a resistive voltage devider 13, 14.

The signal received by photodiode 10 (Fig. 2) is applied
to a controlled-gain amplifyer 15 in the form of an alternating voltage with the frequencies F1 and F2.

This amplifier is connected to a selective filter formed of resistors 16 and 17 and capacitors 18 and 19 attuned to the frequency F1 so as to accentuate it.

The thus processed signal (Fig. 3) is applied to a maximum gain amplifier 20, the output of which is connected to a limiter circuit formed of diodes 22, 23 and a resistor 24. A capacitor 21 is employed in a per se known manner for reducing the gain of amplifier 20 at frequencies below F1 and F2.

The limiter circuit is associated with a voltage divider 25, 26 and cooperates therewith as an antisaturation attenuator limiting the amplitude of the signal (fig. 4) appearing at the output of amplifier 20 to a predetermined maximum level (Fig. 5) as a function of the dimensioning of the receiver.

This signal is applied to a further controlled-gain amplifier 27 corresponding to amplifier 15 and likewise provided with a discriminating filter constituted by resistors 28, 29 and capacitors 30, 31 attuned to the frequency F1.

The amplifier-filter combination 27 - 31 is able to reliably differentiate the frequencies F1 and F2 of the signal, accentuating the frequency F1, thanks to the limited amplitude of the signal applied to its input, which prevents the amplifier itself from attaining the state of saturation. This provision is of partucular importance, since, if the amplifier-filter combination 27 - 31 were to attain its state of saturation due to an input signal of excessively high amplitude (in the case, for instance, that the infrared command signal were received over a short distance and thus with an excessive amplitude), it would no longer be possible to discriminate between the two frequencies F1 and F2. As already said, this problem is overcome by the provision of the attenuator 22 - 26 upstream of the amplifier-filter combination 27 - 31.

The thus obtained signal (fig. 6) is subsequently processed by a peak detector circuit comprising a resistor 32, diodes 33, 34 and capacitors 35, 26, resulting in the signal shown in fig. 7.

The latter signal then passes through two cascade-connected integrators formed respectively of a resistor 37 and a capacitor 38, and a resistor 39 and a capacitor 40. The output 41 of the first integrator is directly applied to the invertin input of a comparator 42 (differential amplifier), while the output 43 of the second integrator controls the non-inverting input of comparator 42.

The signal appearing at output 41 is represented by a continuous line in fig. 8, while the signal at output 43 is shown in broken lines in this figure.

The two signals are substantially identical, although output signal 43 is somewhat attenuated and delayed with respect to output signal 41 due to the effect of the second integrator.

The comparator 42 generates in a per se known manner an output signal in the form of a square wave (fig. 9) representing in digital form the information content of the infrared radiation signal received by photodiode 10.

The described solution thus permits the automatic compensation of the signal applied to comparator 42, as the two signals applied to the inputs of the comparator vary in an analogous manner, so that the relative difference between them is maintained substantially constant.

The circuit according to the invention is thus very simple and reliable, since there are no adjustments required as in the case of a phase-locked loop circuit.

The amplifiers 15, 20, 27 amd 42 are preferably combined in a single integrated circuit (for instance LS 404 by SGS). Otherwide, various modifications of the described embodiment are of course possible within the scope and spirit of the invention.

GRÜNECKER, KINKELDEY, STOCKMAIR & PARTNER

PATENTANWÄLTE
EUROPEAN PATENT ATTORNEYS

A. GRÜNECKER, DIPL.-ING
DR. H. KINKELDEY, DIPL.-ING
DR. W. STOCKMAIR, DIPL.-ING, AE E (CALTECH)
DR. K. SCHUMANN, DIPL.-PHYS
P. H. JAKOB, DIPL.-ING
DR. G. BEZOLD, DIPL.-CHEM
W. MEISTER, DIPL.-ING
H. HILGERS, DIPL.-ING
DR. H. MEYER-PLATH, DIPL.-ING

8000 MÜNCHEN 22
MAXIMILIANSTRASSE 43

**0088830**

EP 895

Infrared Telecommand Receiver

P a t e n t   C l a i m s

1.      A telecommand receiver comprising a photodiode for receiving a signal emitted by a transmitter in the form of a train of amplitude-modulated infrared radiation with two suitably alternating frequencies F1 and F2, an amplifier stage, a peak detector circuit, and an integrator stage adapted to control a comparator, characterized in that downstream of said amplifier stage (15) there is provided an attenuator circuit (22 - 26), followed by a controlled-gain amplifier (27) in combination with a discriminator filter (28 - 31).

2.      A telecommand receiver according to claim 1, characterized in that the output of said integrator stage (37, 38) is directly connected to one input of said comparator (42), and is further connected to the other input of said comparator through a further integrator stage (39, 40).

3.    A telecommand receiver according to claim 1, characterized in that said discriminator filter (28 - 31) associated with said controlled-gain amplifier (27) is attuned to one of said frequencies (F1, F2).

4.    A telecommand receiver according to claim 1, characterized in that a maximum-gain amplifier (20) is interposed between said amplifier stage (15) and said attenuator circuit (22-26).

FIG. 1

FIG.2    FIG.3    FIG.4    FIG.5    FIG.6    FIG.7    FIG.8    FIG.9

0088830

EP 82112076.3

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| A | FUNKTECHNIK, vol. 36, no. 8, 1981, "Einfache Einkanal-Infrarotfernsehsteuerung für 9-V-Batteriebetrieb" <br><br> HÜTHIG-VERLAG, München-Heidelberg pages 283,284 <br><br> * Fig. 2 * | 1 | H 03 J 9/06 <br> H 04 N 5/44 <br> H 04 B 9/00 |
| A | FUNKTECHNIK, vol. 35, no. 10, 1980, "Aus einem Guß: Fernsteuer- und Abstimmsystem" <br><br> HÜTHIG-VERLAG, München-Heidelberg pages W 374-W 384 <br><br> * Fig. 5; page W 374, right column, lines 4-7; page W 378, right column, line 21 - page W 381, left column, line 44 * | 1 | |
| A | DE - B2 -1 962 197 (BURROUGHS) <br><br> * Fig. 1,3,4; column 5, line 3 - column 7, line 32 * | 1 | **TECHNICAL FIELDS SEARCHED (Int. Cl. ³)** <br><br> H 04 B 9/00 <br> H 04 L 27/00 <br> H 04 N 5/00 <br> H 04 Q 9/00 <br> H 03 D 13/00 |
| A | Dipl.-Ing. G. KRAUS "Einführung in die Datenübertragung", 1978 <br><br> R. OLDENBOURGH VERLAG, München pages 107-111 <br><br> * Page 109, line 18 - page 110, line 17 * | 1 | H 03 J 1/00 <br> H 03 J 9/00 <br> G 08 C 23/00 |

The present search report has been drawn up for all claims

| Place of search <br> VIENNA | Date of completion of the search <br> 08-06-1983 | Examiner <br> DRÖSCHER |
|---|---|---|